# EUROPÄISCHE PATENTSCHRIFT

(11) **EP 0 878 912 B1**
(45) Veröffentlichungstag und Bekanntmachung des Hinweises auf die Patenterteilung: **30.07.2003**
(21) Anmeldenummer: 98108530.1
(22) Anmeldetag: 08.05.1998
(51) Int. Cl.: H03L 7/095

(54) **Einrasterkennungsschaltung für einen Phasenregelkreis**
Lock detector circuit for a phase locked loop
Circuit de détection de verrouillage pour une boucle à verrouillage de phase

(30) Priorität: 15.05.1997 DE 19720446
(43) Veröffentlichungstag der Anmeldung: 18.11.1998
(73) Patentinhaber: Infineon Technologies AG, 81669 München (DE)
(72) Erfinder: Vowe, Achim, Dr., 80469 München (DE)
(74) Vertreter: Jannig, Peter, Dipl.-Ing.

(56) Entgegenhaltungen:
- EP-A- 0 637 138
- EP-A- 0 647 017
- EP-A- 0 783 204
- US-A- 5 220 295
- CARNES M L ET AL: "CYCLE-SYNCHRONIZED PHASE-LOCKED LOOP" IBM TECHNICAL DISCLOSURE BULLETIN., Bd. 23, Nr. 1, Juni 1980, Seite 81/82 XP002060801 NEW YORK US

## Beschreibung

Die Erfindung betrifft eine Einrasterkennungsschaltung für einen Phasenregelkreis bestehend aus mindestens zwei Zählern und einer Vergleichereinrichtung, der die Zählerstände der beiden Zähler zugeführt werden, die Vergleichereinrichtung eine Zählerstandsüberprüfungseinrichtung aufweist, in der die Zählerstände überwacht werden und der Phasenregelkreis in den eingerasteten Zustand gesteuert wird, wenn einer der beiden Zählerstände einen vorgegebenen Endwert erreicht.

Phasenregelkreise (PLL, Phase-Locked-Loop) werden verwendet, um Frequenzunterschiede zwischen einem Eingangssignal und einem Vergleichssignal auszuregeln. D.h. der Phasenregelkreis führt die Frequenz eines Vergleichssignals der Frequenz des Eingangssignals nach. Die Frequenz des Vergleichssignals ist entweder direkt die Ausgangsfrequenz des Phasenregelkreises oder sie steht über einen Teiler in einem definierten Verhältnis zur Ausgangsfrequenz. Das für den Regelvorgang benötigte Fehlersignal wird aus der Phasendifferenz zwischen dem Eingangssignal und dem Vergleichssignal mit Hilfe eines Phasendetektors gewonnen.

So lange die Frequenzen des Eingangssignals und des Vergleichssignals weit auseinander liegen, fällt die Differenzfrequenz außerhalb des Durchlaßbereichs des Tiefpaßfilters und es entsteht keine Fehlerspannung am Eingang des Oszillators (VCO) des Phasenregelkreises. Der Oszillator schwingt dann mit der Freilauffrequenz. In diesem Fall ist der Phasenregelkreis nicht eingerastet.

Nähern sich jedoch die Frequenzen des Eingangssignals und des Ausgangssignals einander an, so tritt der Fall ein, daß die Differenzfrequenz in den Durchlaßbereich des Tiefpaßfilters gelangt. Man spricht hier von einem eingerasteten Phasenregelkreis. Eine Schaltungsanordnung, die erkennt, ob der Phasenregelkreis sich im eingerasteten Zustand befindet, wird als Einrasterkennungsschaltung oder Lock-Detektor-Schaltung bezeichnet. Eine derartige Einrasterkennungsschaltung erzeugt ein binäres Steuersignal, das beispielsweise immer dann 0 ist, wenn der Phasenregelkreis nicht eingerastet ist, und auf 1 schaltet, sobald der Phasenregelkreis einrastet.

EP 0 637 138 zeigt eine solche Einrasterkennungsschaltung.

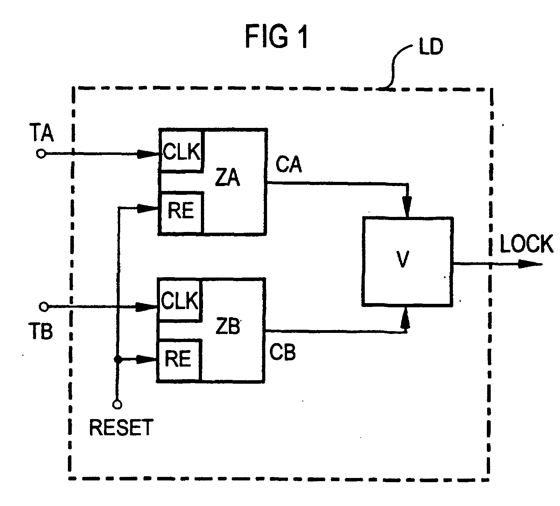

Figur 1 zeigt das Blockschaltbild einer gattungsgemäßen Einrasterkennungsschaltung für einen Phasenregelkreis. Jeweils ein Eingangstaktsignal TA, TB werden in einen Zähler ZA, ZB eingekoppelt. Das erste Eingangssignal TA kann dabei beispielsweise das heruntergeteilte Ausgangssignal des Phasenregelkreises sein. Das zweite Eingangssignal TB kann das Referenzsignal sein, das beispielsweise von einem Quarzoszillator erzeugt wird.

Am Ausgang der Zähler ZA, ZB sind die Zählerstandsignale CA, CB abgreifbar. Die Zählerstände CA, CB der beiden Zähler ZA, ZB werden einer Vergleichereinrichtung V zugeführt. Am Ausgang der Vergleichereinrichtung V ist ein Einrastsignal LOCK abgreifbar. Über einen Reseteingang RE können die Zähler ZA, ZB auf Null zurückgesetzt werden.

Nachfolgend wird die Funktionsweise der in Figur 1 dargestellten Einrasterkennungsschaltung LD näher erläutert.

Im folgenden wird angenommen, daß die beiden Zähler ZA, ZB negativ flakengetriggert sind. Sie können je nach Anforderung auch positiv flankengetriggert sein. Die Zähler ZA, ZB ermitteln anhand der Taktfrequenz der eingekoppelten Eingangssignale TA, TB die Zählerstände CA, CB.

Wenn einer der beiden Zähler, beispielsweise Zähler ZA, einen vorgegebenen Endwert, beispielsweise 100 erreicht hat, dann muß der zweite Zähler ZB ebenfalls den vorgegebenen Wert 100 erreichen, bevor die ansteigende Flanke des in den ersten Zähler ZA eingekoppelten Taktsignales TA erscheint. Für diesem Fall erzeugt die Vergleichereinrichtung V an ihrem Ausgang ein binäres Steuersignal LOCK = 1, das den Phasenregelkreis in den eingerasteten Zustand steuert. Die Zählerstände der Zähler ZA, ZB werden gleichzeitig über ein Resetsignal RESET zurückgesetzt.

Im nicht eingerasteten Zustand unterscheiden sich die Zählerstände CA, CB, nachdem einer der beiden Zähler ZA, ZB den vorgegebenen Wert erreicht hat, beispielsweise um mehr als eine Taktperiode. In diesem Fall gibt die Vergleichereinrichtung ein binäres Steuersignal LOCK = 0 aus, wodurch der Phasenregelkreis in den nicht eingerasteten Zustand gesteuert wird.

Die oben beschriebene Einrasterkennungsschaltung wird üblicherweise als Sicherheitsschaltung zur Erkennung von groben Frequenzunterschieden, beispielsweise durch einen System-Reset, verwendet.

Bei integrierten Schaltungen, insbesondere hochintegrierten Mikroprozessoren und Mikrokontrollern, werden zunehmend Stromsparmodi gefordert. Ein derartiger Stromsparmodus ist beispielsweise der Power-Down-Modus. Im Power-Down-Modus werden Funktionseinheiten der integrierten Schaltung bzw. des Mikroprozessors abgeschaltet oder stark verlangsamt und somit die integrierte Schaltung bzw. der Mikroprozessor in einen quasi Ruhezustand versetzt. Im Power-Down-Modus wird insbesondere der Phasenregelkreis ausgeschaltet. Allerdings ist es erforderlich, daß am Ende des Power-Down-Modus die Einrasterkennungsschaltung verläßlich erkennt, ob der Phasenregelkreis eingerastet oder nicht eingerastet ist.

Eine derartige Schaltungsanordnung erweist sich allerdings als problematisch, da durch die integrale Aufsummierung der in die Zähler ZA, ZB eingekoppelten Takte Frequenzabweichung unendeckt bleiben können, wenn sie innerhalb der durch den vorgegebenen Endwert der Zähler gegebene Zählperiode im Mittel kompensiert werden. Dies ist insbesondere dann der Fall, wenn.der vorgegebene Endwert sehr groß gewählt wird.

Wenn beispielsweise am Anfang der vorgegebenen Zählperiode eine Änderung der Frequenz eines der beiden eingekoppelten Taktsignale auftritt, hat der Phasenregelkreis so lange Zeit auf diese Unregelmäßigkeit zu reagieren und eventuell zu kompensieren, bis einer der beiden Zähler den vorgegebenen Endwert erreicht hat. Wenn jedoch die Frequenzstörung am Ende der vorgegebenen Taktperiode auftritt, hat der Phasenregelkreis nicht mehr die Zeit darauf zu reagieren und den Frequenzunterschied zu kompensieren.

Es kann hier zu dem unerwünschten, sogenannten metastabilen Zustand kommen: Ist das Steuersignal der Einrasterkennungsschaltung LOCK=0, dann ist der Phasenregelkreis tatsächlich im nicht eingerasteten Zustand. Ist jedoch das Steuersignal LOCK=1, dann kann der Phasenregelkreis sich entweder im eingerasteten oder nicht eingerasteten Zustand befinden.

Die Zähler der Einrasterkennungsschaltung entsprechend Figur 1 summieren jeweils die Takte anhand der negativen Flanken der eingekoppelten Takte auf. Die beiden in den Phasenregelkreis eingekoppelten Takte werden in der Weise eingestellt, das jeweils eine der Taktflanken, zum Beispiel die negative Taktflanke, miteinander übereinstimmen. Die positive Taktflanke des eingekoppelten PLL-Taktes stimmt jedoch üblicherweise nicht mit der positiven Taktflanke des Referenztaktes überein, da das Tastverhältnis des eingekoppelten PLL-Taktes vom Taktgenerator des Anwenders der externen Beschaltung und das Tastverhältnis des Referenztaktes vom eingestellten PLL-Faktor abhängen. Da die Empfindlichkeit der Einrasterkennungsschaltung von der relativen Lage der positiven und negativen Taktflanken zueinander abhängt, kann es ebenfalls unerwünschter Weise dazu kommen, daß der Phasenregelkreis in den nicht eingerasteten Zustand gesteuert wird, obwohl er schon eingerastet ist.

Aufgabe der vorliegenden Erfindung ist es daher, eine neue Einrasterkennungsschaltung für einen Phasenregelkreis bereitzustellen, die ohne Zeitverzögerung und unabhängig von der relativen Lage der Referenzflanken der zu vergleichenden Signale Frequenzunterschiede sofort erkennt und den Phasenregelkreis ohne Verzögerung in einen eingerasteten oder nicht eingerasteten Zustand steuert. Desweiteren soll bei einem Ausfallen mindestens eines der eingekoppelten Taktsignale, zum Beispiel bei einem Quarzbruch, die Einrasterkennungsschaltung weiterhin funktionsfähig bleiben.

Erfindungsgemäß wird diese Aufgabe durch eine Einrasterkennungsschaltung für einen Phasenregelkreis der eingangs genannten Art gelöst, der dadurch gekennzeichnet ist, daß
- die Vergleichereinrichtungen eine Komparatoreinrichtung enthält, in der kontinuierlich die Differenz der Zählerstände ermittelt wird und der Phasenregelkreis in den nicht eingerasteten Zustand gesteuert wird, wenn die Differenz der Zählerstände einen vorgegebenen Schwellenwert überschreitet,
- bei Überschreiten des vorgegebenen Schwellenwertes oder bei Erreichen des vorgegebenen Endwertes werden die Zählerstände auf Null zurückgesetzt.

Durch die erfindungsgemäße Einrasterkennungsschaltung werden die Zählerstände der beiden Zähler ständig miteinander verglichen. Ist die Differenz der Zählerstände größer als ein vorgegebener Schwellenwert, dann wird ohne Verzögerung der Phasenregelkreis in den nicht eingerasteten Zustand gesteuert. Wird der Schwellenwert unterschritten, dann wird das Vergleichen der Zählerstände solange wiederholt, bis ein vorgegebener Endwert erreicht ist. Bei Erreichen dieses vorgegebenen Endwertes werden beide Zähler durch eine Reset-Einrichtung auf Null zurückgesetzt.

Durch die erfindungsgemäße Einrasterkennungsschaltung lassen sich somit Frequenzunterschiede sofort erkennen und der Phasenregelkreis ohne Zeitverzögerung in einen eingerasteten oder nicht eingerasteten Zustand setzen. Insbesondere bei Schaltungsanordnungen mit Power-Down-Modus ist es sehr wichtig, daß beim Wiedereinschalten bzw. Hochfahren des Phasenregelkreises der eingerastete Zustand des Phasenregelkreises sofort verläßlich erkannt wird.

In der Vergleichereinrichtung ist eine Zählerstandsüberprüfungseinrichtung vorgesehen, die überprüft, ob der vorgegebenen Endwert schon erreicht ist. Die Zählerstandsüberprüfungseinrichtung kann vorteilhafte Weise durch ein einfaches Master-Slave-Flip-Flop realisiert sein.

Die Differenz der Zählerstände in den Vergleichereinrichtungen werden durch eine Komparatoreinrichtung ermittelt. Die Komparatoreinrichtung kann in einer sehr einfachen Ausführungsform ein einfacher Komparator sein, der bitweise die Zählerstände miteinander vergleicht.

In einer vorteilhaften Weiterbildung der Erfindung weist die neue Einrasterkennungsschaltung mindestens eine zweite, separate Vergleichereinrichtungen auf, die symmetrisch zur ersten Vergleichereinrichtungen aufgebaut ist. In beiden Vergleichereinrichtungen wird separat die Differenz der Zählerstände ermittelt. Jede Vergleichereinrichtung wird separat von dem jeweiligen Zähler angesteuert. Fällt eine der beiden Vergleichereinrichtungen, beispielsweise durch einen Quarzbruch, aus, dann wird der Phasenregelkreis durch die andere Vergleichereinrichtung ohne Verzögerung in den nicht eingerasteten Zustand gesetzt.

Vorteilhafterweise werden die Takte in den Zählern anhand derselben Taktflanke, typischerweise der negativen Referenztaktflanke, gezählt. Es sind selbstverständlich auch positiv flankengetriggerte Zähler denkbar.

In einer vorteilhaften Weiterbildung weist die Vergleichereinrichtung eine Synchronisiereinrichtung auf, die zur Vermeidung von metastabilen Zuständen die zueinander asynchronen Zählerstandsignale synchronisiert. Die Synchronisiereinrichtungen werden in einer bevorzugten Ausführung durch ein einfaches Master-Slave-Flip-Flop realisiert. Durch geschickte Wahl der Synchronisationszeitpunkte kann überdies verhindert werden, daß im LOCK=1-Fall ein versehentlicher Übergang LOCK=1 zu LOCK=0 durch Einfangen eines metastabilien Zustandes erfolgt. Die Synchronisiereinrichtungen lassen sich jedoch anders realisieren.

Typischerweise werden in den Vergleichereinrichtungen nach jeweils vier Takten die Differenz der Zählerstände überprüft. Wird eine genauere Auflösung gewünscht, dann kann die Differenz für Zählerstände auch nach ein oder zwei Takten kontrolliert werden. Ist hingegen sehr häufig Überprüfung der Zählerstände nicht erforderlich, zum Beipiel bei einer sehr großen vorgegebenen Zählperiode, dann kann die Überprüfung der Differenz der Zählerstände auch nach mehr als vier Takten vorgenommen werden.

Der Schwellenwert in den beiden Vergleichereinrichtungen wird typischerweise mit 2 angenommen. Wird die vorgegebene Zählperiode sehr groß gewählt, dann kann jedoch dieser Schwellenwert größer als 2 gewählt werden. Wird hingegen eine sehr feine Auflösung zur Erkennung von geringsten Frequenzungenauigkeiten gewünscht, dann kann der Schwellenwert einen geringeren Wert annehmen.

Typischerweise ist der vorgegebene Schwellenwert mindestens zwei Takte bzw. ist mindestens um den Faktor 100 kleiner als die durch den vorgegebenen Endwert vorgegebene Zählperiode.

In einer vorteilhaften Ausgestaltung der Erfindung lassen sich der vorgegebene Endwert und der vorgegebene Schwellenwert von außen durch den Anwenderbeispielsweise programmgesteuert einstellen. Dadurch ist es möglich, die Einrasterkennungsschaltung an die gewünschten Anforderungen einzustellen. Sowohl vorgegebener Endwert als auch vorgegebener Schwellenwert können überdies vom Signalverlauf des Einrastsignals abhängig gemacht werden. Beispielsweise könnte der vorgegebene Schwellenwert für LOCK=0 2 und im eingerasteten Zustand 4 betragen. Diese Hysterese würde zusätzlich verhindern, daß die Einrasterkennungsschaltung nach einem Übergang vom nichteingerasteten in den eingerasteten Zustand auf ein Überschwingen des Phasenregelkreises zu empfindlich reagiert und kurzzeitig wieder in den uneingerasteten Zustand zurückfällt. Dies hätte dann die Folge, daß die den Phasenregelkreis umgebenden Systeme dies unter Umständen als ein Versagen des Phasenregelkreises interpretieren und den Phasenregelkreis womöglich stillegen würden.

Die Zählerstände in den Zählern werden typischerweise über einen Reset-Manager zurückgesetzt. Dieser Reset-Manager hat in einer vorteilhaften Ausführung eine sehr kurze Verzögerungszeit. Besonders einfach läßt sich der Reset-Manager durch ein logisches ODER-Gatter realisieren.

Die Erfindung wird nachfolgend anhand der in den Figuren der Zeichnung angegebenen Ausführungsbeispiele näher erläutert. Es zeigt:
- Figur 1: das Blockschaltbild einer Einrasterkennungsschaltung für einen Phasenregelkreis nach dem Stand der Technik;
- Figur 2: das Blockschaltbild der erfindungsgemäßen Einrasterkennungsschaltung;
- Figur 3: den Aufbau einer Vergleichereinrichtung der erfindungsgemäßen Einrasterkennungsschaltung.

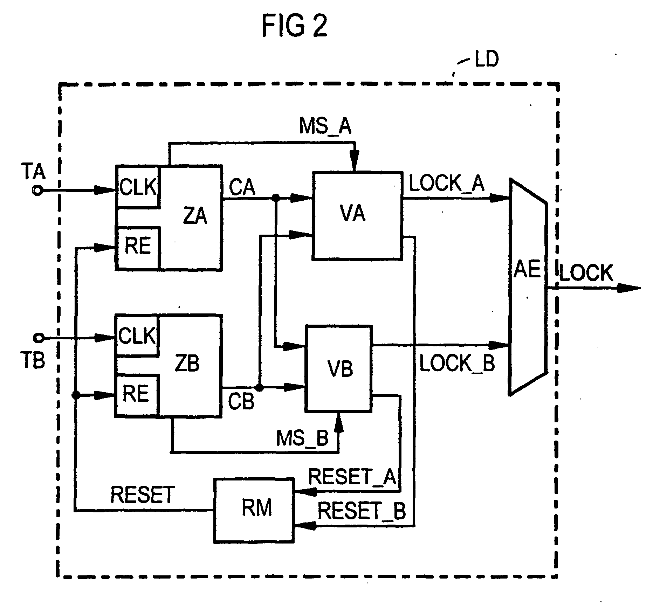

Figur 2 zeigt das Blockschaltbild einer erfindungsgemäßen Einrasterkennungsschaltung LD für einen Phasenregelkreis.

Die Einrasterkennungsschaltung LD enthält einen ersten und zweiten Zähler ZA, ZB. In den ersten Zähler ZA wird ein erstes Eingangstaktsignal TA eingekoppelt. In den zweiten Zähler ZB wird ein zweites Eingangstaktsignal TB eingekoppelt. Das erste Eingangstaktsignal TA kann beispielsweise das heruntergeteilte Ausgangstaktsignal des Phasenregelkreises sein. Das zweite Eingangstaktsignal TB ist das Referenztaktsignal, das beispielsweise von einem Quarzoszillator erzeugt wird. Die beiden Eingangstaktsignale TA, TB werden jeweils an den Takteingängen CLK der Zähler ZA, ZB eingekoppelt.

Die beiden Zähler ZA, ZB zählen die Takte des heruntergeteilten PLL-Ausgangstaktsignales bzw. des Referenztaktsignales. Da im vorliegenden Beispiel der Phasenregelkreis in der Weise konzipiert ist, daß jeweils die negativen Referenzflanken der beiden eingekoppelten Taktsignale TA, TB miteinander übereinstimmen, sind die Zähler ZA, ZB negativ flankengetriggert,.

Am Ausgang der Zähler ZA, ZB ist jeweils ein Zählerstandsignal CA, CB abgreifbar. Den beiden Zählern ZA, ZB sind zwei Vergleichereinrichtungen VA, VB nachgeschaltet. Die Zählerstände CA, CB der beiden Zähler ZA, ZB werden jeweils beiden Vergleichseinrichtungen VA, VB zugeführt. Zusätzlich werden die Vergleichereinrichtungen VA, VB von jeweils einem Master-Slave-Steuersignal MS_A, MS_B des jeweiligen Zählers ZA, ZB angesteuert. Diese Master-Slave-Steuersignale MS_A, MS_B werden in den Zählern ZA, ZB aus den Taktsignalen TA, TB erzeugt.

An einem ersten Ausgang der Vergleichereinrichtungen VA, VB ist jeweils ein Einrastsignal LOCK_A, LOCK_B abgreifbar. Diese Einrastsignale LOCK_A, LOCK_B werden einer Auswahleinrichtung AE zugeführt. Die Auswahleinrichtung AE erzeugt ein weiteres Einrastsignal LOCK, das den Phasenregelkreis in den eingerasteten oder nicht eingerasteten Zustand steuert. Die Auswahleinrichtung AE kann auf einfache Weise durch ein logisches UND-Gatter realisiert sein.

An den zweiten Ausgängen der Vergleichereinrichtungen VA, VB sind die Reset-Signale RESET_A, RESET_B, abgreifbar. Die Reset-Signale RESET_A, RESET_B werden einem Reset-Manager RM zugeführt. Ausgangsseitig erzeugt der Reset-Manager RM ein Reset-Signal RESET, welches in den Reset-Eingang RE der Zähler ZA, ZB eingekoppelt wird. Durch das Reset-Signal RESET werden die Zählerstände CA, CB in den Zählern ZA, ZB auf 0 zurückgesetzt. Der Reset-Manager RM weist üblicherweise eine sehr kurze Verzögerungszeit auf. In einer sehr typischen und einfachen Ausführung läßt sich der Reset-Manager als einfaches ODER-Gatter realisieren.

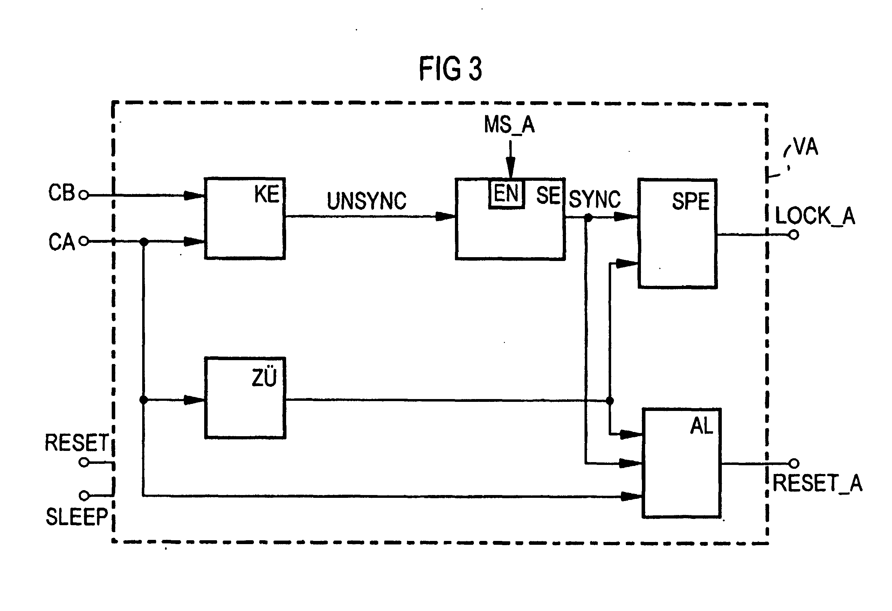

Figur 3 zeigt den Aufbau einer Vergleichereinrichtung VA der erfindungsgemäßen Einrasterkennungsschaltung LD aus Figur 2. Gleiche Elemente sind entsprechend Figur 2 mit gleichen Bezugszeichen versehen.

Im vorliegenden Beispiel werden die Zählerstände CA, CB des ersten und zweiten Taktzählers ZA, ZB einer Komparatoreinrichtung KE eingekoppelt. Die Komparatoreinrichtung KE kann beispielsweise durch einen einfachen Komparator, der bitweise die Zählerstände CA, CB miteinander vergleicht, realisiert sein. Das Ausgangssignal UNSYNC der Komparatoreinrichtung KE wird einer Synchronisiereinrichtung SE zugeführt.

Die Synchronisiereinrichtung SE wird durch ein Steuersignal MS_A, welches vom ersten Zähler ZA erzeugt wird, gesteuert. Ausgangsseitig ist an der Synchronisiereinrichtung SE das Ausgangssignal SYNC abgreifbar.

Zusätzlich wird der Zählerstand CA des ersten Taktzählers ZA einer Zählerstandsüberprüfungeinrichtung ZÜ zugeführt. Die Zählerstandsüberprüfungseinrichtung ZÜ überprüft, ob der Zählerstand CA des ersten Taktzählers ZA den vorgegebenen Endwert schon erreicht hat. Die Ausgangssignale der Zählerstandsüberprüfungseinrichtung ZÜ und der Synchronisiereinrichtung SE werden einer Speichereinrichtung SPE zugeführt. Die Speichereinrichtung SPE speichert die letzte Einrastbedingungen. Die Speichereinrichtung SPE kann typischerweise durch ein RS-Flip-Flop realisiert sein. Am Ausgang der Speichereinrichtung SPE ist das Einrastsignal LOCK_A abgreifbar, welches der Auswahleinrichtung AE zugeführt wird.

Das Zählerstandssignal CA, das Ausgangssignal SYNC der Synchronisiereinrichtung SE sowie das Ausgangssignal der Zählerstandsüberprüfungseinrichtung ZÜ werden einer zweiten Auswahllogikeinrichtung AL zugeführt. Am Ausgang der Auswahllogikeinrichtung AL ist das Reset-Signal RESET_A abgreifbar. Die Auswahllogikeinrichtung AL kann beispielsweise durch ein ineinander verschaltetes AND- und NOR-Gatter ausgebildet sein.

Die Vergleichereinrichtung VA entsprechend Figur 3 weist zusätzlich einen Reset-Eingang RESET und einen Sleep-Eingang SLEEP auf. Über den Reset-Eingang RESET werden die MS-Flip-Flops der Synchronisiereinrichtung SE und der Zählerstandsüberwachungseinrichtung ZÜ zurückgesetzt. Über den Sleep-Eingang SLEEP ist es möglich, die Vergleichereinrichtung VA in den Power-Down-Modus zu schalten bzw. vom Power-Down-Modus in den eingeschalteten Zustand zu schalten.

Die neue Einrasterkennungsschaltung LD arbeitet wie folgt: Wenn während eines Zählvorganges die Differenz der Zählerstände CA, CB größer ist als ein vorgegebener Schwellenwert, darin sind an den beiden Ausgängen der Vergleichereinrichtungen VA, VB die Einrastsignale LOCK_A, LOCK_B gleich 0. Damit wird auch das Einrastsignal LOCK am Ausgang der Auswahleinrichtung AE Zu LOCK = 0. Der Phasenregelkreis wird in den nicht eingerasteten Zustand gesetzt.

Gleichzeitig werden über die Auswahllogikeinrichtungen AL die Reset-Signale RESET_A, RESET_B erzeugt, die über den Reset-Manager RM die Zählerstände CA, CB der Zähler ZA, ZB auf 0 zurücksetzen.

Ist jedoch während eines Zählvorganges die Differenz der Zählerstände CA, CB kleiner als der vorgegebene Schwellenwert, dann wird der Zählvorgang und die Überprüfung der Differenz der Zählerstände CA, CB so lange fortgesetzt, bis einer der Zählern ZA, ZB ein vorgegebener Endwert erreicht. Das Erreichen des vorgegebenen Endwertes wird von der Zählerstandsüberprüfungseinrichtung ZÜ überwacht. In diesem Fall erzeugen die Vergleichereinrichtungen VA, VB ein Einrastsignal LOCK_A, LOCK_B gleich 1. Das Einrastsignal LOCK am Ausgang der Auswahleinrichtung AE wird LOCK = 1. Gleichzeitig werden über die Auswahllogikeinrichtung AL und den Reset-Manager RM die Zählerstände CA, CB auf 0 zurückgesetzt.

Im vorliegenden Beispiel wird der vorgegebene Schwellenwert mit zwei Takten angenommen. Wird eine genauere Auflösung gefordert, kann der vorgegebene Schwellenwert auch mit einem Takt angenommen werden. Es ist jedoch auch denkbar, die vorgegebene Zähldauer, die durch den vorgegebenen Endwert festgelegt wird, sehr groß zu wählen. In diesem Fall oder wenn die Ungenauigkeiten gering sind, ist auch ein vorgegebener Schwellenwert denkbar, der größer ist als zwei Takte.

Nachfolgend wird die Funktionsweise der einzelnen Funktionsblöcke Einrasterkennungsschaltung LD und der Vergleichereinrichtungen VA, VB entsprechend der Figuren 2 und 3 genauer beschrieben.

Die Zähler ZA, ZB sind im vorliegenden Beispiel Bittaktzähler mit asynchronem Reset. Die Zähler enthalten ein Master-Slave-Register und einen Aufwärtszähler. Am Ausgang der Zähler ZA, ZB ist ein Signal mit dem aktuellen Zählerstand CA, CB abgreifbar. In den ersten Zähler ZA wird der von dem Phasenregelkreis heruntergeteilte Ausgangstakt eingekoppelt. In den zweiten Zähler ZB wird der Referenztakt, der beispielsweise durch einen Quarzoszillator bereitgestellt wird, angekoppelt. Die beiden Zähler ZA, ZB sind im Design typischerweise baugleich.

Zusätzlich kann in den Zählern ZA, ZB eine Taktgenerierungseinrichtung vorgesehen sein. Die Taktgenerierungseinrichtung erzeugt nicht überlappende Taktsignale mit positiver und negativer Referenzflanke aus dem eingekoppelten Taktsignal TA, TB. Diese Taktsignale sind im vorliegenden Beispiel die Master-Slave-Steuersignale MS_A, MS_B. Die Takterzeugungseinrichtung muß jedoch nicht notwendigerweise in den Zählern ZA, ZB vorgesehen sein, sondern kann auch extern realisiert sein. Entsprechend den beiden Zählern ZA, ZB sind auch die Takterzeugungseinrichtungen im Design weitgehend baugleich.

Der Reset-Manager RM verbindet die beiden eingekoppelten Reset-Signale RESET_A, RESET_B. Im wesentlichen besteht der Reset-Manager RM aus einem logischen ODER-Gatter, welches an seinem Ausgang ein gemeinsames Reset-Signal RESET erzeugt. Dieses Reset-Signal RESET wird in den Reset-Eingang RE der Zähler ZA, ZB eingekoppelt. Über das Reset-Signal RESET werden die beiden Zähler ZA, ZB auf 0 zurückgesetzt. Nachdem die Zähler ZA, ZB auf 0 zurückgesetzt wurden, wird der Reset-Manager RM ebenfalls zurückgesetzt und das Reset-Signal RESET wird inaktiv gesetzt.

Durch den symmetrischen Aufbau der Einrasterkennungsschaltung LD ist es möglich, daß bei Ausfallen eines der eingekoppelten Takte, beispielsweise bei einem Quarzbruch, die Funktion der Einrasterkennungsschaltung LD erhalten bleibt und der Phasenregelkreis sofort in den nicht eingerasteten Zustand gesteuert wird. Der Phasenregelkreis kann dann durch einen Nottakt weiter betrieben werden.

Die Synchronisiereinrichtung SE synchronisiert das asynchrone Komparatorausgangssignal UNSYNC. Dabei wird an einem Steuereingang der Synchronisiereinrichtung SE ein Steuersignal eingekoppelt, das die Synchronisiereinrichtung SE nur zu Zeitpunken einschaltet, wenn die beiden eingekoppelten Eingangstaktsignale TA, TB synchron zueinander verlaufen. Auf diese Weise lassen sich metastabile Zustände vermeiden. Es ist somit gewährleistet, daß am Ausgang der Synchronisiereinrichtung SE ein bezüglich der beiden eingekoppelten Eingangstaktsignale TA, TB synchrones Ausgangssignal SYNC abgreifbar ist.

Über den Sleep-Anschluß SLEEP läßt sich durch Abschalten der Einrasterkennungsschaltung LD ein definierter Zustand erzeugen. Dies ist insbesondere beim Test der Schaltung von Bedeutung.

Im Power-Down-Modus ist der Phasenregelkreis ausgeschaltet und somit nicht eingerastet. Wird der Phasenregelkreis wieder eingeschaltet, beginnt der Phasenregelkreis, den Referenztakt auf die Sollfrequenz einzuregeln. Durch die erfindungsgemäße Einrasterkennungsschaltung wird sichergestellt, daß erst dann der Phasenregelkreis in den Status "eingerastet" gesetzt wird, wenn der Regelvorgang im Rahmen der geforderten Genauigkeit abgeschlossen ist.

Durch die Wahl des vorgegebenen Schwellwertes der Einrasterkennungsschaltung ist es darüber hinaus möglich, die Einrastbedingungen günstig zu wählen und ein eventuelles Überschwingen des Phasenregelkreises beim Einschwingen, beispielsweise durch einen großen vorgegebenen Schwellenwert, zu vermeiden. Im Normalbetrieb des Phasenregelkreises, in dem kein Überschwingen der Frequenzen zu erwarten sind, könnte dann ein geringerer vorgegebener Schwellenwert eingestellt werden.

Besonders vorteilhaft ist es daher, den vorgegebenen Schwellenwert extern einzustellen. Dies ermöglicht dem Anwender je nach Anforderungen bzw. Auflösung diesen vorgegebenen Schwellenwert frei zu wählen. Des weiteren ist es vorteilhaft, den durch den vorgegebenen Endwert bestimmten Taktperiode ebenfalls extern einstellen zu können.

Die vorliegende erfindungsgemäße Einrasterkennungsschaltung LD kann sowohl für einen analogen als auch für einen digitalen Phasenregelkreis verwendet werden. Bei einem analogen Phasenregelkreis muß hierbei eingangs der Einrasterkennungsschaltung LD ein Anpaßmechanismus vorgesehen sein, der die analogen Signale in konventionelle digitale Signale umwandelt.

## Patentansprüche

1. Einrasterkennungsschaltung für einen Phasenregelkreis bestehend aus mindestens zwei Zählern (ZA, ZB) und einer Vergleichereinrichtung (VA), der die Zählerstände (CA, CB) der beiden Zähler (ZA, ZB) zugeführt werden, die Vergleichereinrichtung (VA) eine Zählerstandsüberprüfungseinrichtung (ZÜE) aufweist, in der die Zählerstände (CA, CB) überwacht werden und der Phasenregelkreis in den eingerasteten Zustand gesteuert wird, sobald einer der beiden Zählerstände (CA, CB) einen vorgegebenen Endwert erreicht,
**dadurch gekennzeichnet, daß**
- die Vergleichereinrichtungen (VA) eine Komparatoreinrichtung (KE) enthält, in der kontinuierlich die Differenz der Zählerstände (CA, CB) ermittelt wird und der Phasenregelkreis in den nicht eingerasteten Zustand gesteuert wird, sobald die Differenz der Zählerstände einen vorgegebenen Schwellenwert überschreitet,
- bei Überschreiten eines vorgegebenen Schwellenwertes spätestens aber bei Erreichen eines vorgegebenen Endwertes werden die Zählerstände (CA, CB) auf Null zurückgesetzt.

2. Einrasterkennungsschaltung nach Anspruch 1,
**dadurch gekennzeichnet,**
**daß** mindestens eine weitere Vergleichereinrichtung (VB) vorgesehen ist, die bezüglich der eingekoppelten Eingangstaktsignale (TA, TB) symmetrisch zur ersten Vergleichereinrichtung (VA) aufgebaut ist, wobei jeder der Vergleichereinrichtungen (VA, VB) die Zählerstände (CA, CB) des ersten und des zweiten Zählers (ZA, ZB) zugeführt werden und jede der Vergleichereinrichtungen (VA, VB) separat von jeweils einem unterschiedlichen Steuersignal (MS_A, MS_B) gesteuert werden.

3. Einrasterkennungsschaltung nach einem der Ansprüche 1 oder 2,
**dadurch gekennzeichnet,**
**daß** jeder der Zähler (ZA, ZB) anhand derselben Referenzflanke des eingekoppelten Taktsignals (TA, TB) die Zählerstände (CA, CB) ermittelt.

4. Einrasterkennungsschaltung nach einem der Ansprüche 1 bis 3,
**dadurch gekennzeichnet,**
**daß** die Zähler (ZA, ZB) flankengetriggert sind.

5. Einrasterkennungsschaltung nach einem der Ansprüche 1 bis 4,
**dadurch gekennzeichnet,**
**daß** jede der Vergleichereinrichtungen jeweils eine Synchronisiereinrichtung (SE) aufweist, welche die Zählerstandsignale synchronisiert.

6. Einrasterkennungsschaltung nach einem der Ansprüche 1 bis 5,
**dadurch gekennzeichnet,**
**daß** die Vergleichereinrichtungen (VA, VB) jeweils nach vier Takten die Differenz der Zählerstände (CA, CB) überprüft.

7. Einrasterkennungsschaltung nach einem der Ansprüche 1 bis 6,
**dadurch gekennzeichnet,**
**daß** der vorgegebene Schwellenwert größer als 2 ist.

8. Einrasterkennungsschaltung nach einem der Ansprüche 1 bis 6,
**dadurch gekennzeichnet,**
**daß** der vorgegebene Schwellenwert größer mindestens um den Faktor 100 kleiner ist als der vorgegebene Endwert.

9. Einrasterkennungsschaltung nach einem der Ansprüche 1 bis 8,
**dadurch gekennzeichnet,**
**daß** der vorgegebene Endwert und/oder der vorgegebene Schwellenwert einstellbar sind.

10. Einrasterkennungsschaltung nach einem der Ansprüche 1 bis 9,
**dadurch gekennzeichnet,**
**daß** die Zählerstände (CA, CB) in den Taktzählern (ZA, ZB) durch einen Reset-Manager (RM) zurückgesetzt werden.

## Claims

1. Lock detector circuit for a phase-locked loop comprising at least two counters (ZA, ZB) and a comparison device (VA), to which the counter readings (CA, CB) of the two counters (ZA, ZB) are fed; the comparison device (VA) has a counter reading checking device (ZÜE) in which the counter readings (CA, CB) are monitored and the phase-locked loop is controlled into the locked state as soon as one of the two counter readings (CA, CB) reaches a predetermined final value,
**characterized in that**
- the comparison device (VA) contains a comparator device (KE) in which the difference between the counter readings (CA, CB) is continuously determined and the phase-locked loop is controlled into the non-locked state as soon as the difference between the counter readings exceeds a predetermined threshold value,
- when a predetermined threshold value is exceeded, but at the latest when a predetermined final value is reached, the counter readings (CA, CB) are reset to zero.

2. Lock detector circuit according to Claim 1,
**characterized in that**
at least one further comparison device (VB) is provided which, with regard to the input clock signals (TA, TB) that are coupled in, is constructed symmetrically to the first comparison device (VA), the counter readings (CA, CB) of the first and second counters (ZA, ZB) being fed to each of the comparison devices (VA, VB) and each of the comparison devices (VA, VB) being controlled separately by a respectively different control signal (MS_A, MS_B).

3. Lock detector circuit according to either of Claims 1 and 2,
**characterized in that**
each of the counters (ZA, ZB) determines the counter readings (CA, CB) using the same reference edge of the clock signal (TA, TB) that is coupled in.

4. Lock detector circuit according to one of Claims 1 to 3,
**characterized in that**
the counters (ZA, ZB) are edge-triggered.

5. Lock detector circuit according to one of Claims 1 to 4,
**characterized in that**
each of the comparison devices has a respective synchronization device (SE), which synchronizes the counter reading signals.

6. Lock detector circuit according to one of Claims 1 to 5,
**characterized in that**
the comparison devices (VA, VB) checks the difference between the counter readings (CA, CB) in each case after four clock cycles.

7. Lock detector circuit according to one of Claims 1 to 6,
**characterized in that**
the predetermined threshold value is greater than 2.

8. Lock detector circuit according to one of Claims 1 to 6,
**characterized in that**
the predetermined threshold value is smaller than the predetermined final value at least by a factor of 100.

9. Lock detector circuit according to one of Claims 1 to 8,
**characterized in that**
the predetermined final value and/or the predetermined threshold value are adjustable.

10. Lock detector circuit according to one of Claims 1 to 9,
**characterized in that**
the counter readings (CA, CB) in the clock counters (ZA, ZB) are reset by a reset manager (RM) .

## Revendications

1. Circuit de détection de verrouillage pour un circuit régulateur de phase composé d'au moins deux compteurs (ZA, ZB) et d'un dispositif comparateur (VA) auquel sont acheminées les positions de comptage (CA, CB) des deux compteurs (ZA, ZB), le dispositif comparateur (VA) présente un dispositif de contrôle de position de comptage (ZÜE) dans lequel sont surveillées les positions de comptage (CA, CB) et le circuit régulateur de phase est amené en situation de verrouillage dès que l'une des deux positions de comptage (CA, CB) atteint une valeur finale prédéfinie, **caractérisé en ce que**
- les dispositifs de comparaison (VA) contiennent un dispositif comparateur (KE) dans lequel la différence entre les positions de comptage (CA, CB) est déterminée en permanence et le circuit régulateur de phase est amené en situation de non-verrouillage dès que la différence des positions de comptage devient supérieure à une valeur de seuil prédéfinie,
- les positions de comptage (CA, CB) sont remises à zéro lorsqu'une valeur de seuil prédéfinie est dépassée ou au plus tard lorsqu'une valeur finale prédéfinie est atteinte.

2. Circuit de détection de verrouillage selon la revendication 1, **caractérisé en ce qu'**il est prévu au moins un dispositif de comparaison (VB) supplémentaire qui est construit de manière symétrique par rapport au premier dispositif de comparaison (VA) du point de vue des signaux d'horloge d'entrée (TA, TB) injectés, les positions de comptage (CA, CB) du premier et du deuxième compteur (ZA, ZB) étant acheminées à chacun des dispositifs de comparaison (VA, VB) et chacun des dispositifs de comparaison (VA, VB) étant commandé séparément à chaque fois par un signal de commande (MS_A, MS_B) différent.

3. Circuit de détection de verrouillage selon l'une des revendications 1 ou 2, **caractérisé en ce que** chacun des compteurs (ZA, ZB) détermine les positions de comptage (CA, CB) à l'aide des mêmes fronts de référence du signal d'horloge injecté (TA, TB).

4. Circuit de détection de verrouillage selon l'une des revendications 1 à 3, **caractérisé en ce que** les compteurs (ZA, ZB) sont déclenchés par des fronts.

5. Circuit de détection de verrouillage selon l'une des revendications 1 à 4, **caractérisé en ce que** chacun des dispositifs de comparaison présente à chaque fois un dispositif de synchronisation (SE) qui synchronise les signaux de position de comptage.

6. Circuit de détection de verrouillage selon l'une des revendications 1 à 5, **caractérisé en ce que** les dispositifs de comparaison (VA, VB) contrôlent la différence entre les positions de comptage (CA, CB) à chaque fois après quatre cycles.

7. Circuit de détection de verrouillage selon l'une des revendications 1 à 6, **caractérisé en ce que** la valeur de seuil prédéfinie est supérieure à 2.

8. Circuit de détection de verrouillage selon l'une des revendications 1 à 6, **caractérisé en ce que** la valeur de seuil prédéfinie est au moins inférieure d'un facteur 100 à la valeur finale prédéfinie.

9. Circuit de détection de verrouillage selon l'une des revendications 1 à 8, **caractérisé en ce que** la valeur finale prédéfinie et/ou la valeur de seuil prédéfinie sont réglables.

10. Circuit de détection de verrouillage selon l'une des revendications 1 à 9, **caractérisé en ce que** les positions de comptage (CA, CB) dans les compteurs de cycles (ZA, ZB) sont remises à zéro par un gestionnaire de réinitialisation (RM).
